# EUROPÄISCHE PATENTSCHRIFT

(11) **EP 2 145 353 B1**
(45) Veröffentlichungstag und Bekanntmachung des Hinweises auf die Patenterteilung: **14.10.2015**
(21) Anmeldenummer: 08856002.4
(22) Anmeldetag: 08.12.2008
(51) Int. Cl.: H01L 31/056, H01L 31/048

(54) **PHOTOVOLTAIKMODULE MIT REFLEKTIERENDEN KLEBEFOLIEN**
PHOTOVOLTAIC MODULES HAVING REFLECTIVE ADHESIVE FILMS
MODULES PHOTOVOLTAÏQUES DOTÉS DE FILMS ADHÉSIFS RÉFLÉCHISSANTS

(30) Priorität: 07.12.2007 DE 102007055733
(43) Veröffentlichungstag der Anmeldung: 20.01.2010
(60) Teilanmeldung: 10178420.5
(73) Patentinhaber: Kuraray Europe GmbH, 65795 Hattersheim (DE)
(72) Erfinder: KARPINSKI, Andreas, 51519 Odenthal (DE); KELLER, Uwe, 53177 Bonn (DE); HENKEL, Michael, 53840 Troisdorf (DE)
(86) Internationale Anmeldenummer: PCT/EP2008/067041
(87) Internationale Veröffentlichungsnummer: WO 2009/071703

(56) Entgegenhaltungen:
- EP-A- 1 995 789
- EP-A1- 1 795 337
- EP-B1- 2 087 526
- WO-A1-02/102591
- DE-A1- 4 337 694
- JP-A- 2008 115 344
- US-A- 5 059 254
- US-A- 5 656 098
- US-A1- 2007 235 077

## Beschreibung

### Technisches Gebiet

Die Erfindung betrifft die Herstellung von Photovoltaikmodulen unter Verwendung von Sonnenlicht-Reflektierenden Klebefolien, insbesondere von weichmacherhaltigen Folien auf Basis von Polyvinylacetal.

### Stand der Technik

Photovoltaikmodule bestehen aus einer photosensitiven Halbleiterschicht, die zum Schutz gegen äußere Einflüsse mit einer transparenten Abdeckung versehen wird. Als photosensitive Halbleiterschicht können monokristalline Solarzellen oder polykristalline, dünne Halbleiterschichten auf einem Träger eingesetzt werden. Dünnschicht-Solarmodule bestehen aus einer photosensitiven Halbleiterschicht, die auf eine meist transparente Platte z.B. durch Aufdampfen, Gasphasenabscheidung, Sputtern oder Nassabscheidung aufgebracht ist.

Beide Systeme werden häufig zwischen eine Glasscheibe und eine rigide, hintere Abdeckplatte z.B. aus Glas oder Kunststoffen mit Hilfe eines transparenten Klebers laminiert.

Der transparente Kleber muss die photosensitive Halbleiterschicht und deren elektrische Verbindungsleitungen vollständig umschließen, UV-stabil und Feuchtigkeitsunempfindlich sein und nach dem Laminierprozess vollständig blasenfrei sein.

Als transparente Kleber werden häufig aushärtende Gießharze oder vernetzbare, auf Ethylenvinylacetat (EVA) basierende Systeme eingesetzt, so wie beispielsweise in DE 41 22 721 C1 oder DE 41 28 766 A1 offenbart.

Eine Alternative zu aushärtenden Klebesystemen ist der Einsatz von weichmacherhaltigen Folien auf Basis von Polyvinylacetalen wie das aus der Verbundglasherstellung bekannte Polyvinylbutyral (PVB). Die Solarzelleneinheiten werden mit einer oder mehreren PVB-Folien bedeckt und diese unter erhöhtem Druck und erhöhter Temperatur mit den gewünschten Abdeckmaterialien zu einem Laminat verbunden.

Verfahren zur Herstellung von Solarmodulen mit Hilfe von PVB-Folien sind z. B. durch DE 40 26 165 C2, DE 42 278 60 A1, DE 29 237 70 C2, DE 35 38 986 C2 oder US 4,321,418 bekannt. Die Verwendung von PVB-Folien in Solarmodulen als Verbundsicherheitsverglasungen ist z.B. in DE 20 302 045 U1, EP 1617487 A1, und DE 35 389 86 C2 offenbart.

Das auf die photosensitive Schicht der Solarmodule auftretende Sonnenlicht durchdringt diese teilweise und geht für eine Umwandlung in elektrische Energie verloren. Um den Wirkungsgrad von Solarmodulen zu verbessern, werden diese häufig mit einer reflektierenden Rückseite ausgerüstet. Hierzu werden z.B. eine Spiegelschicht oder reflektierende Pigmente in Form einer zusätzlichen Schicht auf die Module aufgebracht. Dieses Verfahren ist aufwändig, da so in das Solarmodul eine zusätzliche Schicht eingebraucht werden muss. Zudem dürfen die elektrisch leitfähigen Spiegelschichten oder reflektierende Pigmente nicht in Kontakt mit der photosensitiven Schicht treten, da sonst die Gefahr von Kurzschlüssen besteht.

Ein zunehmend wichtiger werdendes Merkmal der Klebefolien für Photovoltaikmodule ist deren elektrische Leitfähigkeit, da mit zunehmender Leistungsfähigkeit der photosensitiven Halbleiterschichten bei gleichzeitigem Einsatz auch unter humiden Umweltbedingungen immer höhere Anforderungen an die Isolationsfähigkeit der Folie gestellt werden.

Ladungsverluste oder gar Kurzschlüsse der Halbleiterschicht müssen auch unter extremen Witterungsbedingungen wie tropische Temperaturen, hohe Luftfeuchtigkeit oder starke UV-Strahlung über die gesamte Lebensdauer des Moduls vermieden werden. Photovoltaikmodule werden dem nach IEC 61215 einer Vielzahl von Tests unterzogen (Damp heat test, wet leakage current test) um Verlustströme der Module zu reduzieren. Um dies zu erreichen, müssen die Klebefolien einen möglicht hohen spezifischen Widerstand aufweisen

### Aufgabe

Aufgabe der vorliegenden Erfindung ist es daher, Photovoltaikmodule in konstruktiv einfacher Weise mit einer reflektierenden Schicht zur Leistungssteigerung auszurüsten.

Hierzu ist es aus DE 4337694 A1 US2007/0235077 A1 und EP2087526 B1 bekannt, reflektierende Klebefolien auf Basis von Polyvinylbutyral einzusetzen. Dokument EP 2087526 gehört zum Stand der Technik gemäß Artikel 54(3) EPÜ.

Wie bereits ausgeführt, weisen viele der bekannten Photovoltaikmodule Klebeschichten auf. Überraschenderweise wurde gefunden, dass diese Klebeschichten in einfacher Weise mit reflektierenden Eigenschaften ausgestattet werden können.

### Darstellung der Erfindung

Gegenstand der vorliegenden Erfindung sind daher Photovoltaikmodule gemäß des Hauptanspruchs.

Durch die diffus reflektierend ausgerüstete Klebefolie wird ein Teil des Lichts, das die photosensitive Halbleiterschicht durchdringt, wieder auf diese zurückreflektiert, sodass sich die Effektivität des Moduls erhöht.

Entscheidend für die Effizienzverbesserung der erfindungsgemäßen Photovoltaikmodule ist der Strahlungsreflexionsgrad bzw. die Reflexionseigenschaften der reflektierenden Klebefolie. Dieser wird, wie in den Beispielen angegeben, an glatten (d.h. abgepressten) Folien gemäß DIN EN 410 bestimmt und beträgt mindestens 15 % oder 25 %, mindestens jedoch 30 %, bevorzugt mindestens 50 % und insbesondere mindestens 70 %.

Solche Messungen können auf einem UV/VIS-Spektrometer "Lambda 950" des Herstellers Perkin-Elmer durchgeführt werden. Nach DIN EN 410 wird der Strahlungsreflexionsgrad im Wellenlängenbereich 300 - 2500 nm bestimmt.

Photovoltaikmodule, die einen prinzipiellen Aufbau Glas/ photosensitive Halbleiterschicht/erfindungsgemäße reflektierende Klebefolie/Glas aufweisen, zeigen einen Leistungsgewinn von ca. 0,5 bis 5 % gegenüber einem gleich aufgebauten Photovoltaikmodul ohne reflektierende Klebefolie (d.h. mit einer Klebefolie gleicher Zusammensetzung aber ohne reflektierende Eigenschaften).

Mit der erfindungsgemäß eingesetzten reflektierenden Klebefolie können Photovoltaikmodule gleicher Leistung eine um die Leistungssteigerung kleinere Fläche aufweisen.

Bevorzugt enthält die Klebefolie reflektierende Pigmente. Unter Reflektion wird im Rahmen der vorliegenden Erfindung eine Reflektion der für die photosensitive Halbleiterschicht in elektrische Energie umwandelbare Strahlung, in der Regel die Strahlung im UV-Bereich, dem Wellenlängenbereich des sichtbaren Lichts und des nahen IR-Bereichs, verstanden.

Als reflektierende Pigmente sind insbesondere die sogenannten Weißpigmente, dass heißt Pigmente mit einem Brechungsindex von mehr als 1,8 gut geeignet. Hierzu zählen ein oder mehrere Weißpigmente der Gruppe Titandioxid, Lithopone, Bariumsulfat, Zinkoxid, Zinksulfid und Bleicarbonat. Alternativ oder zusätzlich können als reflektierende Pigmente auch ein oder mehrere Metalle der Gruppe Al, Zn, Cr, oder Ti eingesetzt werden. Siliziumdioxid ist für den erfindungsgemäßen Einsatz nicht geeignet.

Die Zwischenschicht kann zwischen zwei Klebefolien einlaminiert sein, sodass sich an den Außenseiten die gewünschte Klebewirkung ergibt.

Die Zwischenschicht besteht aus mindestens einer pigmentfreien und mindestens einer pigmenthaltigen Teilschicht. So können z.B. die außen liegenden Teilschichten eine Klebewirkung bewirken, währen die innen liegende, die reflektierenden Pigmente enthaltende Teilschicht für die Reflexion der Strahlung sorgt.

Folien mit mehreren Teilschichten können durch Zusammenlegen von vorgefertigten Teilschichten oder durch Coextrusion der Teilschichten in einem Arbeitsgang hergestellt werden.

Der Anteil der reflektierenden Pigmente in der reflektierenden Klebefolie beträgt bevorzugt 0.1 bis 25 Gew.%, insbesondere 1 bis 20 Gew.%, besonders bevorzugt 1 bis 10 Gew.%. Ist die Klebefolie aus pigmentfreien und pigmenthaltigen Teilschichten aufgebaut, so bezieht sich dieser Wert auf die Gesamtfolie, sodass in der pigmenthaltigen Teilschicht entsprechend der Dickenverteilung höhere Konzentrationen eingesetzt werden können.

Im Fall, das die Zwischenschicht aus mindestens einer pigmentfreien und mindestens einer pigmenthaltigen Teilschicht besteht, können diese Teilschichten jeweils eine unterschiedliche oder gleiche Zusammensetzung bzw. polymere Materialien enthalten.

Als Material für die reflektierenden Klebe- und Teilschichten können die für Verbundverglasungen bekannten Materialien eingesetzt werden, wie z.B. weichmacherhaltige Polyvinylacetale oder Polyvinylbutyrale.

Die weichmacherhaltiges Polyvinylacetal enthaltenden Folien enthalten bevorzugt unvernetztes Polyvinylbutyral (PVB), das durch Acetalisierung von Polyvinylalkohol mit Butyraldehyd gewonnen wird.

Der Einsatz von vernetzten Polyvinylacetalen, insbesondere vernetztem Polyvinylbutyral (PVB) ist ebenso möglich. Geeignete vernetzte Polyvinylacetale sind z.B. in EP 1527107 B1 und WO 2004/063231 A1 (thermische Selbstvernetzung von Carboxylgruppenhaltigen Polyvinylacetalen), EP 1606325 A1 (mit Polyaldehyden vernetzte Polyvinylacetale) und WO 03/020776 A1 (mit Glyoxylsäure vernetzte Polyvinylacetale) beschrieben. Auf die Offenbarung dieser Patentanmeldungen wird vollumfänglich Bezug genommen.

Es ist auch möglich, die Acetalisierung mit anderen oder weiteren Aldehyden mit 5-10 Kohlenstoffatomen (z.B. wie Valeraldehyd) durchzuführen.

Als Polyvinylalkohol können im Rahmen der vorliegenden Erfindung auch Terpolymere aus hydrolysierten Vinylacetat/Ethylen-Copolymeren eingesetzt werden. Diese Verbindungen sind in der Regel zu mehr als 98% hydrolysiert und enthalten 1 bis 10 Gew. auf Ethylen basierende Einheiten (z.B. Typ "Exceval" der Kuraray Europe GmbH).

Polyvinylacetale enthalten neben den Acetaleinheiten noch aus Vinylacetat und Vinylalkohol resultierende Einheiten. Die erfindungsgemäß verwendeten Polyvinylacetale weisen bevorzugt einen Polyvinylalkoholanteil von weniger als 18 Gew.%, weniger als 16 Gew.% oder insbesondere weniger als 14 Gew.% auf. Ein Polyvinylalkoholanteil von 12 Gew.% sollte nicht unterschritten werden.

Der Polyvinylacetatanteil liegt bevorzugt unter 5 Gew.%, bevorzugt unter 3 Gew.% und insbesondere unter 2 Gew.% Aus dem Polyvinylalkoholanteil und dem Restacetatgehalt kann der Acetalisierungsgrad rechnerisch ermittelt werden.

Die erfindungsgemäß eingesetzten Folien weisen bei einer Umgebungsfeuchte von 85% rF bei 23°C bevorzugt einen spezifischen Widerstand von mindestens 1E+11 ohm*cm, bevorzugt mindestens 5E+11 ohm*cm, bevorzugt 1E+12 ohm*cm, bevorzugt 5E+12 ohm*cm, bevorzugt 1E+13, bevorzugt 5E+13 ohm*cm, bevorzugt 1E+14 ohm*cm auf.

Bevorzugt weisen die erfindungsgemäß eingesetzten Folien, insbesondere solche auf Basis von weichmacherhaltigem Polyvinylacetal, einen Weichmachergehalt von maximal 40 Gew.%, 35 Gew.%, 32 Gew.%, 30 Gew.%, 28 Gew.%, 26 Gew.%, 24 Gew.%, 22 Gew.%, 20 Gew.%, 18 Gew.%, 16 Gew.% auf, wobei ein Weichmachergehalt von 15 Gew.% aus Gründen der Verarbeitbarkeit der Folie nicht unterschritten werden sollte (jeweils bezogen auf die gesamte Folienformulierung). Erfindungsgemäße Folien bzw. Photovoltaikmodule können einen oder mehrere Weichmacher enthalten.

Grundsätzlich geeignete Weichmacher für die erfindungsgemäß eingesetzten Folien auf Basis von Polyvinylacetalen sind eine oder mehrere Verbindungen ausgewählt aus den folgenden Gruppen:
- Ester von mehrwertigen aliphatischen oder aromatischen Säuren, z.B. Dialkyladipate wie Dihexyladipat, Dioctyladipat, Hexylcyclohexyladipat, Mischungen aus Heptyl- und Nonyladipaten, Diisononyladipat, Heptylnonyladipat sowie Ester der Adipinsäure mit cycloaliphatischen oder Etherbindungen enthaltenden Esteralkoholen, Dialkylsebazate wie Dibutylsebazat sowie Ester der Sebazinsäure mit cycloaliphatischen oder Etherbindungen enthaltenden Esteralkoholen, Estern der Phthalsäure wie Butylbenzylphthalat oder Bis-2-butoxyethylphthalat
- Ester oder Ether von mehrwertigen aliphatischen oder aromatischen Alkoholen oder Oligoetherglykolen mit einem oder mehreren unverzweigten oder verzweigten aliphatischen oder aromatischen Substituenten, wie z.B. Estern von Di-, Tri- oder Tetraglykolen mit linearen oder verzweigten aliphatischen oder cycloaliphatischen Carbonsäuren; Als Beispiele für letztere Gruppe können dienen Diethylenglykol-bis-(2-ethylhexanoat), Triethylenglykol-bis-(2-ethylhexanoat), Triethylenglykol-bis-(2-ethylbutanoat), Tetraethylenglykol-bis-n-heptanoat, Triethylenglykol-bis-n-heptanoat, Triethylenglykol-bis-n-hexanoat, Tetraethylenglykoldimethylether und/oder Dipropylenglykolbenzoat
- Phosphate mit aliphatischen oder aromatischen Esteralkoholen wie z.B. Tris(2-ethylhexyl)phosphat (TOF), Triethylphosphat, Diphenyl-2-ethylhexylphosphat, und/oder Trikresylphosphat
- Ester der Zitronensäure, Bernsteinsäure und/oder Fumarsäure

Gut geeignet als Weichmacher für die erfindungsgemäß eingesetzten Folien auf Basis von Polyvinylacetalen sind eine oder mehrere Verbindungen ausgewählt aus der folgenden Gruppe Di-2-ethylhexylsebacat (DOS), Di-2-ethylhexyladipat (DOA), Dihexyladipat (DHA), Dibutylsebacat (DBS), Triethylenglykol-bis-n-heptanoat (3G7), Tetraethylenglykol-bis-n-heptanoat (4G7), Triethylenglykol-bis-2-ethylhexanoat (3GO bzw. 3G8) Tetraethylenglykol-bis-n-2-ethylhexanoat (4GO bzw. 4G8) Di-2-butoxyethyladipat (DBEA), Di-2-butoxyethoxyethyladipat (DBEEA) Di-2-butoxyethylsebacat (DBES), Di-2-ethylhexylphthalat (DOP), Di-isononylphthalat (DINP) Triethylenglykol-bis-isononanoat, Triethylenglykol-bis-2-propylhexanoat, Tris(2-ethylhexyl)phosphat (TOF), 1,2-Cyclohexandicarbonsäurediisononylester (DINCH) und Dipropylenglykolbenzoat.

Ganz besonders geeignet als Weichmacher für die erfindungsgemäß eingesetzten Folien auf Basis von Polyvinylacetalen sind Weichmacher, deren Polarität, ausgedrückt durch die Formel 100 x O/(C+H) kleiner/gleich 9.4 ist, wobei O, C und H für die Anzahl der Sauerstoff-, Kohlenstoff- und Wasserstoffatome im jeweiligen Molekül steht. Die nachfolgende Tabelle zeigt erfindungsgemäß einsetzbare Weichmacher und deren Polaritätswerte nach der Formel 100 x O/(C+H).

| Name | Abkürzung | 100 x O/(C+H) |
|---|---|---|
| Di-2-ethylhexylsebacat | (DOS) | 5,3 |
| 1,2-Cyclohexandicarbonsäurediisononylester | (DINCH) | 5,4 |
| Di-2-ethylhexyladipat | (DOA) | 6,3 |
| Di-2-ethylhexylphthalat | (DOP) | 6,5 |
| Dihexyladipat | (DHA) | 7,7 |
| Dibutylsebacat | (DBS) | 7,7 |
| Triethylenglykol-bis-2-propylhexanoat | | 8,6 |
| Triethylenglykol-bis-i-nonanoat | | 8,6 |
| Di-2-butoxyethylsebacat | (DBES) | 9,4 |
| Triethylenglykol-bis-2-ethylhexanoat | (3G8) | 9,4 |

Das Haftungsvermögen von Polyvinylacetalfolien an Glas wird üblicherweise durch die Zugabe von Haftungsregulatoren wie z. B. die in WO 03/033583 A1 offenbarten Alkali- und/oder Erdalkalisalze von organischen Säuren eingestellt. Als besonders geeignet haben sich Kaliumacetat und/oder Magnesiumacetat herausgestellt. Zudem enthalten Polyvinylacetale aus dem Herstellungsprozess häufig Alkali- und/oder Erdalkalisalze von anorganischen Säuren, wie z.B. Natriumchlorid.

Da Salze ebenfalls einen Einfluss auf den spezifischen Widerstand haben, ist der Einsatz von weichmacherhaltigen, auf Polyvinylacetal basierenden Folien mit weniger als 50 ppm, besonders bevorzugt mit weniger als 30 ppm und insbesondere mit weniger als 20 ppm Metallionen zweckmäßig. Dies kann durch entsprechende Waschverfahren des Polyvinylacetals und durch die Verwendung besonders gut wirkender Antihaftmittel wie die dem Fachmann bekannten Magnesium-, Calzium- und/oder Zinksalze organischer Säuren (z.B. Acetate) erreicht werden.

Weiterhin kann die möglicherweise vom Wassergehalt der Folie abhängende Ionenbeweglichkeit und damit der spezifische Widerstand durch den Zusatz von pyrogener Kieselsäure beeinflusst werden. Bevorzugt enthalten die weichmacherhaltigen, auf Polyvinylacetal basierenden Folien 0.001 bis 15 Gew.%, bevorzugt 2 bis 5 Gew.% pyrogenes SiO₂.

Die prinzipielle Herstellung und Zusammensetzung von Folien auf Basis von Polyvinylacetalen ist z. B. in EP 185 863 B1, EP 1 118 258 B1 WO 02/102591 A1, EP 1 118 258 B1 oder EP 387 148 B1 beschrieben.

Die Laminierung der Photovoltaikmodule erfolgt unter Verschmelzung der Folien, so dass ein blasen- und schlierenfreier Einschluss der photosensitiven Halbleiterschicht mit den Folien erhalten wird.

Die Gesamtdicke der Klebefolien liegt üblicherweise bei 0.38, 0.51, 0.76, 1.14, 1.52 oder 2.28 mm.

Erfindungsgemäß eingesetzte Folien füllen während des Laminierprozesses die an den photosensitiven Halbleiterschichten bzw. deren elektrischen Verbindungen vorhandenen Hohlräume aus.

Die transparente Frontabdeckung besteht in der Regel aus Glas oder PMMA. Die rückwärtige Abdeckung des erfindungsgemäßen Photovoltaikmoduls kann aus Glas, Kunststoff oder Metall oder deren Verbünden bestehen, wobei mindestens einer der Träger transparent sein kann. Es ist ebenfalls möglich, einen oder beide Abdeckungen als Verbundverglasung (d. h. als Laminat aus mindestens zwei Glasscheiben und mindestens einer PVB-Folie) oder als Isolierverglasung mit einem Gaszwischenraum auszuführen. Selbstverständlich ist auch die Kombination dieser Maßnahmen möglich.

Die in den Modulen eingesetzten photosensitiven Halbleiterschichten müssen keine besonderen Eigenschaften besitzen. Es können mono-, polykristalline oder amorphe Systeme eingesetzt werden.

Werden erfindungsgemäße Dünnschicht-Solarmodule hergestellt, so sind die photosensitiven Halbleiterschichten in der Regel direkt auf die transparente Frontabdeckung aufgebracht und mit der rückwärtigen Abdeckung durch mindestens eine erfindungsgemäße Klebefolie verklebt.

Im Fall der Herstellung von kristallinen oder geträgerten Solarmodulen müssen die Solarmodule von Klebefolien eingekapselt werden, d.h. dass die photosensitiven Halbleiterschichten b) mit mindestens einer, nicht reflektierenden Klebefolie mit der transparenten Frontabdeckung a) und die rückwärtigen Abdeckung d) durch mindestens eine erfindungsgemäße Klebefolie verklebt sind. Diese Folien weisen bevorzugt bis auf die reflektierenden Pigmente eine gleiche Zusammensetzung wie reflektierende Klebefolien auf.

Zur Laminierung des so erhaltenen Schichtkörpers können die dem Fachmann geläufigen Verfahren mit und ohne vorhergehende Herstellung eines Vorverbundes eingesetzt werden.

So genannte Autoklavenprozesse werden bei einem erhöhten Druck von ca. 10 bis 15 bar und Temperaturen von 130 bis 145 °C über ca. 2 Stunden durchgeführt. Vakuumsack- oder Vakuumringverfahren z.B. gemäß EP 1 235 683 B1 arbeiten bei ca. 200 mbar und 130 bis 145 °C

Vorzugsweise werden zur Herstellung der erfindungsgemäßen Photovoltaikmodule Vakuumlaminatoren eingesetzt. Diese bestehen aus einer beheizbaren und evakuierbaren Kammer, in denen Verbundverglasungen innerhalb von 30 - 60 Minuten laminiert werden können. Verminderte Drücke von 0,01 bis 300 mbar und Temperaturen von 100 bis 200 °C, insbesondere 130 - 160 °C haben sich in der Praxis bewährt.

Alternativ kann ein so oben beschrieben zusammengelegter Schichtkörper zwischen mindestens einem Walzenpaar bei einer Temperatur von 60 bis 150 °C zu einem erfindungsgemäßen Modul verpresst werden. Anlagen dieser Art sind zur Herstellung von Verbundverglasungen bekannt und verfügen normalerweise über mindestens einen Heiztunnel vor bzw. nach dem ersten Presswerk bei Anlagen mit zwei Presswerken.

Erfindungsgemäße Photovoltaikmodule können als Fassadenbauteil, Dachflächen, Wintergartenabdeckung, Schallschutzwand, Balkon- oder Brüstungselement oder als Bestandteil von Fensterflächen verwendet werden.

### Messmethoden:

Die Messung des spezifischen Durchgangswiderstandes der Folie erfolgt gemäß DIN IEC 60093 bei definierter Temperatur und Umgebungsfeuchte (23 °C und 85 % rLF) nachdem die Folie wenigstens 24h bei diesen Bedingungen konditioniert wurde. Zur Durchführung der Messung wurde eine Plattenelektrode Typ 302 132 von der Firma Fetronic GmbH sowie ein Widerstandsmessgerät ISO-Digi 5kV von der Firma Amprobe verwendet. Die Prüfspannung betrug 2,5 kV, die Wartezeit nach Anlegen der Prüfspannung bis zur Messwerterfassung 60 sek. Damit ein ausreichender Kontakt zwischen den flachen Platten der Messelektrode und der Folie gewährleistet ist, sollte deren Oberflächenrauhikgkeit R_{z} bei Messung nach DIN EN ISO 4287 nicht größer als 10 µm sein, d.h. gegebenenfalls muss die Originaloberfläche der PVB-Folie vor der Widerstandsmessung durch thermisches Umprägen geglättet werden.

Der Polyvinylalkohol- und Polyvinylalkoholacetatgehalt der Polyvinylacetale wurde gemäß ASTM D 1396-92 bestimmt. Der Wasser- bzw. Feuchtegehalt der Folien wird mit der Karl-Fischer-Methode bestimmt.

Zur Messung der Reflektionseigenschaften wurde die gegebenenfalls ursprünglich aufgeraute Oberfläche der Klebefolien zunächst zwischen zwei Lagen PET-Folie unter Erwärmen geglättet. Dieser Vorbehandlungsschritt kann natürlich bei Klebefolien entfallen, welche bereits eine glatte Oberfläche aufweisen, bzw. es kann sinnvoll sein, die Oberfläche an einer anderen Schicht als PET zu glätten, falls dieses zu stark mit der Klebefolie verklebt und schlecht abgezogen werden kann. Nach Entfernen der PET-Folie wurde dieser Seite der Klebefolie die Reflexion von Licht der Wellenlänge 380 - 780 nm an einem Spektrophotometer Hitachi U-3410 nach DIN EN 410 unter einem Winkel von 8° bestimmt.

Für die angeführten Beispiele wurde der Strahlungsreflexionsgrad einer glatten bzw. geglätteten Seite der Klebefolie auf einem UV/VIS-Spektrometer "Lambda 950" des Herstellers Perkin-Elmer im Wellenlängenbereich 300 - 2500 nm bestimmt. Weil die Messung an einem planen Muster durchgeführt werden soll, kann die Klebefolie zur Messung auf einen transparenten Träger, z.B. einem Stück Glas befestigt werden.

### Beispiele:

Es wurden weichmacherhaltige Polyvinylbutyralfolien mit reflektierendem Pigment auf ihre Eignung als reflektierende Klebefolie in Photovoltaikmodule untersucht.

So wies eine kommerziell von der Kuraray Europe GmbH erhältliche Folie des Typs "Trosifol Colour W17" (Dicke 0.38 mm) mit ca. 1 Gew.% TiO₂ eine Reflexion von Licht wie oben beschrieben von 68,7 % auf. Ein mit dieser Folie hergestelltes Photovoltaikmodul mit dem Aufbau Glas/ photosensitive Halbleiterschicht/"Trosifol Colour W17"/Glas wiesen eine um 0,75% gesteigerte Leistung gegenüber einem analogen Modul mit handelsüblicher PVB-Folie ohne Pigment auf.

Es wurden ein- oder mehrschichtig aufgebaute Folien auf Basis von weichmacherhaltigem Polyvinylbutyral mit den in den folgenden Tabellen aufgeführten Zusammensetzungen homogen oder partiell mit Titandioxid pigmentiert. Die dreischichtigen Folien wurden durch Coextrusion unter Verwendung eines Feedblock-Verteilers erhalten. Bei den dreischichtigen Folien ist nur die innen liegende Schicht mit Titandioxid als reflektierendem Pigment versehen, während die äußeren Schichten im Wesentlichen nur aus PVB und Weichmacher bestehen und transparent sind. In beiden Fällen, ein- oder mehrschichtig aufgebauten Klebefolien, kann das Weiß- bzw. das metallisch reflektierende Pigment, zunächst im Weichmacher suspendiert und dann zusammen mit dem PVB-Harz zur Folie bzw. der Folienschicht extrudiert werden oder aber als Feststoff direkt in die Einzugszone des Extruders dosiert werden. Für die Beispiele wurden die Pigmente direkt in den laufenden Extruder dosiert.

Mit dieser Folie hergestellte Photovoltaikmodul mit dem Aufbau Glas/ photosensitive Halbleiterschicht/reflektierende Folie /Glas wiesen um eine 0,7 - 1,5 % gesteigerte Leistung gegenüber einem baugleichen Modul mit einer Folie gleicher Zusammensetzung aber ohne Pigmentzusatz auf.

Die Folien bestanden aus weichgemachtem Polyvinylbutyral (PVB) mit dem angegebenen Polyvinylalkoholgehalt (PVOH) in Gew.% und einem Polyvinylacetatgehalt von ca. 1 Gew.% auf.

Weiterhin bedeuten:

| | |
|---|---|
| HOMBITAN | oberflächenbehandeltes TiO₂ vom Rutiltyp, Hersteller: Sachleben Chemie |
| KRONOS 2226 | oberflächenbehandeltes TiO₂ vom Rutilytp, Hersteller: Kronos Titan GmbH |
| KRONOS 2450 | oberflächenbehandeltes TiO₂ vom Rutilytp, Hersteller: Kronos Titan GmbH |
| 1S | Einschichtfolie |
| 3S | Dreischichtfolie |
| * | Anteil in der Mittelschicht |

| Beispiel | 1 | 2 | 3 | 4 | 5 | 6 | |
|---|---|---|---|---|---|---|---|
| Materialtyp | 3S | 3S | 3S | 3S | 1S | 1S | |
| Mowital (PVB) : PVOH 20.0% | 76 | 76 | - | - | 72,5 | - | |
| Mowital (PVB): PVOH 14.0% | - | - | 74 | 74 | - | 76 | |
| Weichmacher 3G8 | 24 | 24 | - | - | 25 | - | |
| Weichmacher DBEA | - | - | - | - | 2,5 | - | |
| Weichmacher DOA | | | 26 | 26 | | | |
| Weichmacher DINCH | - | - | - | - | - | 24 | |
| HOMBITAN (TiO2) | | | | | 2,5 | 5 | |
| KRONOS 2226 (TiO2) | 7,5 * | 7,5 * | | | | | |
| KRONOS 2450 (TiO2) | | | 7,5 * | 7,5 * | | | |
| Gesamtdicke in mm | 0,76 | 0,76 | 0,76 | 0,76 | 0,76 | 0,76 | |
| Dicke Mittelschicht in mm | 0,19 | 0,35 | 0,19 | 0,35 | - | - | |
| Gehalt (Ti02) in Gesamtfolie | 1,4 | 2,9 | 1,2 | 2,3 | 2,5 | 5 | |
| Strahlungsreflektionsgrad 300 - 2500 nm in % nach DIN EN 410 | 69% | 77% | 67% | 75% | 69% | 76% | |
| Durchgangswiderstand nach DIN IEC 60093, klimatisiert:23°C/85%rF | 2,0E+11 | 2,0E+11 | 3,5E+12 | 3,5E+12 | 1,5E+11 | 3,0E+13 | |

| Beispiel | 7 | 8 | 9 | 10 | 11 | 12 | 13 |
|---|---|---|---|---|---|---|---|
| Materialtyp | 1S | 1S | 1S | 1S | 1S | 1S | 1S |
| Mowital (PVB): PVOH 20.0% | 72,5 | 72,5 | 72,5 | 72,5 | 72,5 | 72,5 | 72,5 |
| Mowital (PVB): PVOH 14.0% | - | - | - | - | - | - | - |
| Weichmacher 3G8 | 25 | 25 | 25 | 25 | 25 | 25 | 25 |
| Weichmacher DBEA | 2,5 | 2,5 | 2,5 | 2,5 | 2,5 | 2,5 | 2,5 |
| Weichmacher DOA | | | | | | | |
| Weichmacher DINCH | - | - | - | - | - | - | - |
| HOMBITAN (TiO2) | 5 | 7,5 | 1,316 | 2,63 | 5,13 | 7,5 | 10 |
| KRONOS 2226 (TiO2) | | | | | | | |
| KRONOS 2450 (TiO2) | | | | | | | |
| Gesamtdicke in mm | 0,76 | 0,76 | 0,38 | 0,38 | 0,38 | 0,38 | 0,38 |
| Dicke Mittelschicht in mm | - | - | - | - | - | - | - |
| Gehalt (TiO2) in Gesamtfolie | 5 | 7,5 | 1,316 | 2, 63 | 5,13 | 7,5 | 10 |
| Strahlungsreflektionsgrad 300 - 2500 nm in % nach DIN EN 410 | 75% | 80% | 64% | 71% | 78% | 80% | 82% |
| Durchgangswiderstand nach DIN IEC 60093, klimatisiert:23°C/85%rF | 1,5E+11 | 1,5E+11 | 1,5E+11 | 1,5E+11 | 1,5E+11 | 1,5E+11 | 1,5E+11 |

## Patentansprüche

1. Photovoltaikmodul, umfassend ein Laminat aus
a) einer transparenten Frontabdeckung
b) einer oder mehreren photosensitiven Halbleiterschichten
c) mindestens einer Klebefolie und
d) einer rückwärtigen Abdeckung
**dadurch gekennzeichnet, dass** die eine oder mehreren photosensitiven Halbleiterschichten mit der rückwärtigen Abdeckung durch mindestens eine durch reflektierende Pigmente reflektierend ausgerüstete Klebefolie verklebt sind, wobei die reflektierende Klebefolie aus außen liegenden, pigmentfreien Teilschichten aus weichmacherhaltigem Polyvinylacetal und einer innen liegenden, pigmenthaltigen Teilschicht aus weichmacherhaltigem Polyvinylacetal bestehen und als reflektierendes Pigment Titandioxid verwendet wird.

2. Photovoltaikmodul nach Anspruch 1 **dadurch gekennzeichnet, dass** die reflektierende Klebefolie einen Weichmachergehalt von maximal 40 Gew.% und mindestens 15 Gew.% aufweist.

3. Photovoltaikmodul nach Anspruch 1 oder 2 **dadurch gekennzeichnet, dass** die reflektierende Klebefolie mindestens einen Weichmacher ausgewählt aus der Gruppe Di-2-ethylhexylsebacat (DOS), 1,2-Cyclohexandicarbonsäurediisononylester (DINCH), Di-2-ethylhexyladipat (DOA), Di-2-ethylhexylphthalat (DOP), Dihexyladipat (DHA), Dibutylsebacat (DBS), Triethylenglykol-bis-2-propylhexanoat, Triethylenglykol-bis-i-nonanoat, Di-2-butoxyethylsebacat (DBES) und Triethylenglykol-bis-2-ethylhexanoat (3G8) aufweist.

4. Photovoltaikmodul nach einem der Ansprüche 1 bis 3 **dadurch gekennzeichnet, dass** die reflektierende Klebefolie eine Reflexion nach DIN EN 410 von mindestens 15 % aufweist.

5. Photovoltaikmodul nach einem der Ansprüche 1 bis 4 **dadurch gekennzeichnet, dass** die reflektierende Klebefolie bei einer Umgebungsfeuchte von 85% rF bei 23°C einen spezifischen Widerstand von mindestens 1E+11 ohm*cm besitzen.

## Claims

1. A photovoltaic module comprising a laminate formed from
a) a transparent front cover
b) one or more photosensitive semiconductor layers
c) at least one adhesive film, and
d) a rear cover
**characterised in that** the one or more photosensitive semiconductor layers is/are adhered to the rear cover by at least one adhesive film made reflective by reflective pigments, wherein the reflective adhesive film(s) consists/consist of external pigment-free partial layers formed from plasticiser-containing polyvinyl acetal and an inner pigment-containing partial layer formed from plasticiser-containing polyvinyl acetal, and titanium dioxide is used as reflective pigment.

2. The photovoltaic module according to Claim 1, **characterised in that** the reflective adhesive film has a plasticiser content of at most 40 % by weight and at least 15 % by weight.

3. The photovoltaic module according to Claim 1 or 2, **characterised in that** the reflective adhesive film comprises at least one plasticiser selected from the group di-2-ethylhexyl sebacate (DOS), 1,2-cyclohexane dicarboxylic acid diisononyl ester (DINCH), di-2-ethylhexyl adipate (DOH), di-2-ethylhexyl phthalate (DOP), dihexyl adipate (DHA), dibutyl sebacate (DBS), triethylene glycol-bis-2-propyl hexanoate, triethylene glycol-bis-1-nonanoate, di-2-butoxyethyl sebacate (DBES), and triethylene glycol-bis-2-ethyl hexanoate (3G8).

4. The photovoltaic module according to one of Claims 1 to 3, **characterised in that** the reflective adhesive film has a reflection according to DIN EN 410 of at least 15 %.

5. The photovoltaic module according to one of Claims 1 to 4, **characterised in that** the reflective adhesive film at an ambient humidity of 85 % RH at 23 °C has an electrical resistivity of at least 1E+11 ohm•cm.

## Revendications

1. Module photovoltaïque, comprenant un élément laminé qui est constitué
a) d'une couverture frontale transparente
b) d'une ou de plusieurs couches de semi-conducteur photosensibles
c) d'au moins une feuille adhésive, et
d) d'une couverture arrière
**caractérisé en ce que** lesdites une ou plusieurs couches de semi-conducteur photosensibles sont collées à ladite couverture arrière à travers au moins une feuille adhésive rendue réfléchissante par des pigments réfléchissants, ladite feuille adhésive réfléchissante étant constituée de couches partielles en acétal de polyvinyle contenant des plastifiants lesquelles sont exemptes de pigments et situées à l'extérieur, et d'une couche partielle en acétal de polyvinyle contenant des plastifiants laquelle comporte des pigments et est située à l'intérieur, et que l'on utilise en tant que pigment réfléchissant le dioxyde de titane.

2. Module photovoltaïque selon la revendication 1, **caractérisé en ce que** ladite feuille adhésive réfléchissante présente une teneur en plastifiants inférieure ou égale à 40 % en poids et supérieure ou égale à 15 % en poids.

3. Module photovoltaïque selon les revendications 1 ou 2, **caractérisé en ce que** ladite feuille adhésive réfléchissante comporte au moins un plastifiant choisi dans le groupe de sébaçate de di-2-éthylhexyle (DOS), 1,2-cyclohexandicarboxylate de diisononyle (DINCH), adipate de di-2-éthylhexyle (DOA), phtalate de di-2-éthylhexyle (DOP), adipate de dihexyle (DHA), sébaçate de dibutyle (DBS), bis-(2-propylhexanoate) de triéthylèneglycol, bis-(i-nonanoate) de triéthylèneglycol, sébaçate de di-2-butoxyéthyle (DBES) et de bis-(2-éthylhexanoate) de triéthylèneglycol (3G8).

4. Module photovoltaïque selon l'une des revendications 1 à 3, **caractérisé en ce que** ladite feuille adhésive réfléchissante présente une réflexion supérieure ou égale à 15 % selon la norme DIN EN 410.

5. Module photovoltaïque selon l'une des revendications 1 à 4, **caractérisé en ce que** ladite feuille adhésive réfléchissante possède, à un taux d'humidité relative de 85 % dans son environnement et à 23 °C, une résistance spécifique d'au moins 1E+11 ohm*cm.
